# EUROPEAN PATENT SPECIFICATION

(11) **EP 1 973 385 B1**
(45) Date of publication and mention of the grant of the patent: **02.03.2011**
(21) Application number: 06833037.2
(22) Date of filing: 21.11.2006
(51) Int. Cl.: H05B 33/08, H01L 51/50, H05B 37/02

(54) **AN OLED DRIVER AND LIGHTING APPARATUS EQUIPPED WITH THE DRIVER**
OLED-TREIBER UND MIT EINEM SOLCHEN TREIBER AUSGESTATTETE BELEUCHTUNGSVORRICHTUNG
DISPOSITIF D'ATTAQUE DE DIODES LED ORGANIQUES ET SYSTÈME D'ILLUMINATION MUNI D'UN TEL DISPOSITIF D'ATTAQUE

(30) Priority: 25.11.2005 JP 2005341197
(43) Date of publication of application: 24.09.2008
(73) Proprietor: Panasonic Electric Works Co., Ltd., Kadoma-shi Osaka (JP)
(72) Inventor: MAEHARA, Minoru, Kadoma-shi, Osaka 571-8686 (JP); OKAMOTO, Futoshi, Kadoma-shi Osaka 571-8686 (JP); HIRAMATSU, Akinori, Kadoma-shi Osaka 571-8686 (JP); NAKANO, Tomoyuki, Kadoma-shi Osaka 571-8686 (JP); KAWANAMI, Hiroki, Kadoma-shi Osaka 571-8686 (JP)
(74) Representative: Appelt, Christian W.
(86) International application number: PCT/JP2006/323187
(87) International publication number: WO 2007/060937

(56) References cited:
- WO-A1-03/073798
- JP-A- 8 153 585
- JP-A- 08 153 585
- JP-A- 11 307 245
- JP-A- 2002 535 722
- US-A1- 2004 232 939
- US-A1- 2005 083 323

## Description

### TECHNICAL FIELD

The invention relates to generally OLED drivers and more particularly to an OLED driver for driving at least one organic electroluminescence element and lighting apparatus equipped with the driver.

### BACKGROUND ART

In this sort of lighting apparatus, at least one organic electroluminescence element (hereinafter also referred to as an organic EL element or an OLED (Organic Light Emitting Diode)) is employed as a thin and lightweight light-emitting element and is driven at low drive voltage (e.g., several to tens of volts) in comparison with discharge lamps. Accordingly, since OLED drivers can be produced at low cost in comparison with conventional ballasts, various thin and lightweight OLED drivers have been proposed.

By the way, since actual EL elements do not have enough luminous life to be used for illumination application, extending the life is indispensable to lighting apparatus equipped with an OLED driver. For example, a prior art device described in Japanese Patent No. 2663648 supplies inverse-polarity power to at least one organic EL element. In this device, the luminous life of the element can be extended.

In addition to extending luminous life of at least one organic EL element in this way, it is desirable that, when the element is not normal (e.g., when the element reaches end-of-life or when the element degrades), an OLED driver should operate at predetermined control for the element which is not normal. For example, if lighting apparatus is configured to replaceably mount with a light source formed of at least one organic EL element, it is desirable to notify a user that the light source should be replaced with a new one. It is also desirable to restrain the light output of the light source from falling, to change illumination of the light source or to stop the output.

From document JP 08-153585 A an OLED driver is known, essentially in line with the introductory portion of claim 1.

Document WO 03/073798 A1 discloses a circuit which detects the equivalent capacitance inherent to a light emitting element.

Documents US 2005/0083323 A1 discloses a further light emitting display device and document US 2004/0232939 A1 discloses testing flat panel display plates using high frequency as signals.

### DISCLOSURE OF THE INVENTION

It is therefore an object of the present invention to provide an OLED driver that, if at least one organic electroluminescence element is not normal, operates in accordance with control corresponding to the element which is not normal.

This object is solved by an OLED driver according to claim 1 and a lighting apparatus according to claim 6, comprising such an OLED driver. Claims 2 to 5 refer to specifically advantageous realization of the OLED driver according to claim 1.

An OLED driver of the present invention comprises a square-wave voltage source and a controller. In accordance with first control, the source generates square-wave voltage and applies the voltage across at least one organic electroluminescence element to drive the element. The controller controls the source in accordance with the first control. In an aspect of the present invention, the driver further comprises a detector that detects equivalent capacitance inherent in the element. In addition, the controller judges whether or not the element is normal based on the equivalent capacitance detected with the detector. If the element is normal, the controller operates in accordance with the first control. If the element is not normal, the controller operates in accordance with predetermined second control for the element which is not normal. In this invention, if the element is not normal, the controller can operate in accordance with the predetermined second control for the element which is not normal.

In another aspect of the present invention, the detector measures transient (inrush) current waveform in response to a rise in the voltage applied across the element to detect the equivalent capacitance. In this invention, the equivalent capacitance can be detected.

In an aspect of the present invention, the detector measures discharge current waveform in response to a fall in the voltage applied across the element to detect the equivalent capacitance. In this invention, the equivalent capacitance can be detected.

In an aspect of the present invention, the detector detects the equivalent capacitance per period of the square-wave voltage. In this invention, the equivalent capacitance can be always monitored.

In an aspect of the present invention, the detector detects the equivalent capacitance after a predetermined time elapses from a start of the element. In this invention, it is possible to detect the equivalent capacitance when the temperature of the driven element is stable.

In an aspect of the present invention, the detector detects the equivalent capacitance only for a predetermined time from a start of the element. In this invention, the equivalent capacitance can be detected without the influence of temperature variation of the element.

In an aspect of the present invention, the controller controls the source so as to lower output voltage of the source in case of the second control. In this invention, the life of the element can be further extended.

In an aspect of the present invention, the controller controls the source so as to raise output voltage of the source in case of the second control. In this invention, light output of the element can be restrained from falling.

In an aspect of the present invention, in case of the second control, the controller controls the source so as to change output voltage of the source in response to the equivalent capacitance detected with the detector. In this invention, the element can be adaptively driven in response to degradation condition of the element.

In an aspect of the present invention, the controller controls the source so as to stop the output of the source in case of the second control. In this invention, the element can be prevented from being driven when the element is not normal.

Lighting apparatus of the present invention comprises said OLED driver and said at least one organic electroluminescence element.

### BRIEF DESCRIPTION OF THE DRAWINGS

Preferred embodiments of the invention will now be described in further details. Other features and advantages of the present invention will become better understood with regard to the following detailed description and accompanying drawings where:
FIG. 1 is a schematic diagram of an embodiment according to the present invention;
FIG. 2 is an equivalent circuit of an organic EL element;
FIG. 3 is an explanatory diagram of equivalent capacitance detected with a detector in FIG. 1;
FIG. 4 is an explanatory diagram of equivalent capacitance detected with the detector in FIG. 1;
FIG. 5 is an operation explanatory diagram in a modified embodiment;
FIG. 6 is an operation explanatory diagram in another modified embodiment; and
FIG. 7 is an operation explanatory diagram in a modified embodiment.

### BEST MODE FOR CARRYING OUT THE INVENTION

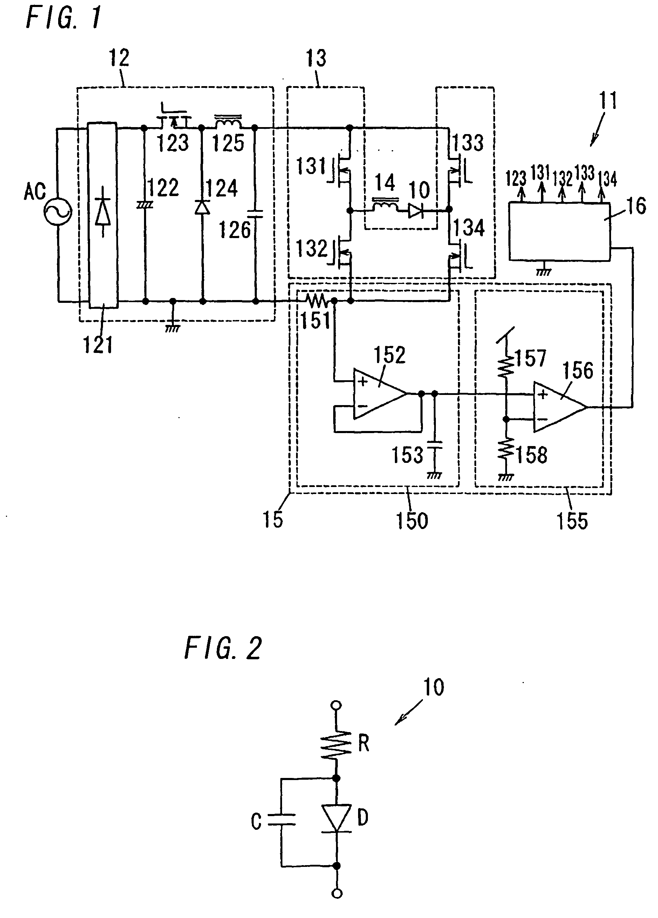

FIG. 1 shows an embodiment according to the present invention, namely lighting apparatus 1. The device 1 possesses at least one organic EL element (OLED) 10 and an OLED driver 11 for driving the element 10.

The organic EL element 10 is formed of an emission layer (an organic thin film) and a pair of electrodes between which the layer is sandwiched from both faces of the layer. The element 10 emits light when electrons injected from one electrode as a cathode recombine with holes injected from other electrode as an anode in the layer.

The OLED driver 11 possesses a square-wave voltage source formed of a direct-current power source 12, a polarity inversion circuit (inverter) 13 and a current-limiting element 14, and also possesses a detector 15 and a controller 16. The driver generates square-wave voltage to apply the voltage across the element 10.

The direct-current power source 12 is configured so that it operates in accordance with first control (e.g., a PWM control signal) from the controller 16 to convert alternating-current power of a commercial power source AC into direct-current power. For example, as shown in FIG. 1, the source 12 is provided with: a diode bridge 121 as a full wave rectifier; a smooth capacitor 122 connected between both output terminals of the bridge 121; and a voltage step down converter connected to both ends of the capacitor 122. The converter is formed of: a switching element (e.g., MOSFET) 123 of which one end is connected to the positive terminal of the capacitor 122; a diode 124 of which cathode and anode are respectively connected to the other end of the element 123 and the negative terminal of the capacitor 122; an inductor 125 of which one end is connected to the other end of the element 123; and a capacitor 126 connected between the other end of the inductor 125 and the anode of the diode 124. In this source 12, the alternating-current power from the source AC is rectified into pulsating direct current power through the bridge 121, and voltage of the pulsating direct current power is smoothed through the capacitor 122. The smoothed voltage is then converted into voltage approximately equal to the drive voltage of the element 10 through the converter, and thereby the above direct-current power is obtained.

The polarity inversion circuit 13 is configured: to operate in accordance with first control (e.g., switching control signals) from the controller 16; and then to periodically invert voltage polarity of the direct-current power from the source 12 to generate square-wave voltage; and to apply the square-wave voltage across the element 10 via the element 14 for limiting a peak value of the inrush current when the polarity is inverted. For example, the circuit 13 is provided with four switching elements (e.g., MOSFETs) 131-134 constituting a full-bridge circuit. The element 14 is, for example, an inductor with current-limiting action and small inductance.

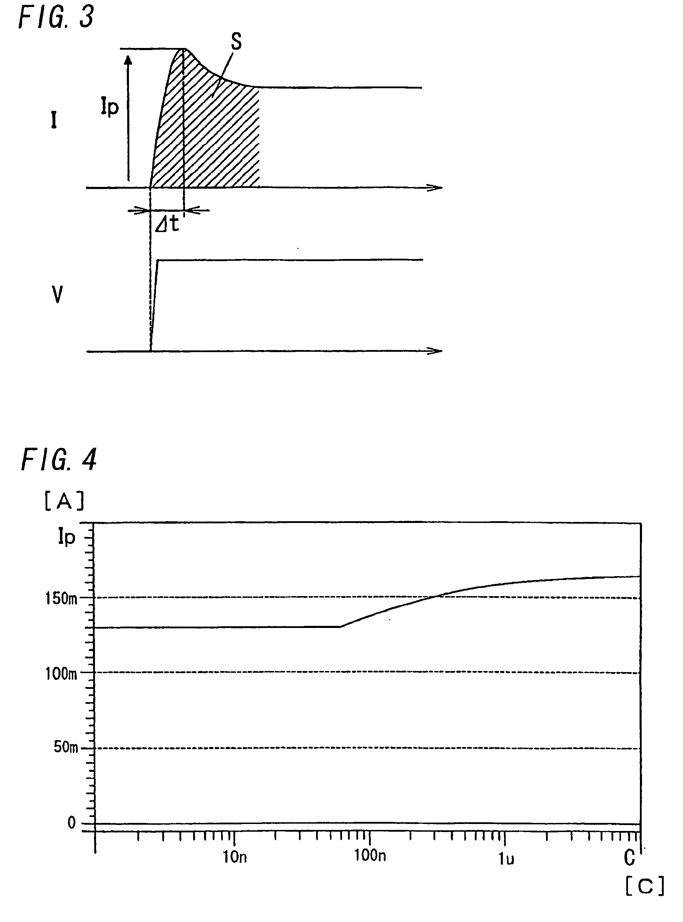

As shown in FIG. 3, the detector 15 is configured to measure transient (inrush) current waveform in response to a rise in square-wave voltage applied across the element 10 to detect equivalent capacitance inherent in the element 10. The equivalent capacitance is first explained with reference to FIGs. 2-4. The element 10 has the structure of plane-parallel condenser and therefore can be represented by the equivalent circuit shown in FIG. 2, where a diode D is connected in parallel with a capacitor C while the parallel combination of the diode D and the capacitor C is connected in series with a resistor R. Therefore, if square-wave voltage is applied across the element 10, an inrush current flows through the element 10 when the polarity of the voltage is inverted as shown in FIG. 3. In general, an inrush current through an element is under influence of equivalent capacitance C of the element as shown in FIG. 4. It is known through experiments that after the capacitance C exceeds a threshold, the peak value Ip of the inrush current increases as the capacitance C increases. It is also known that the equivalent capacitance of an organic EL element exceeds the threshold and also the equivalent capacitance of the organic EL element destroyed by the continuous supply of an excessive current becomes much less than that of a normal organic EL element. Accordingly, the equivalent capacitance of the element 10 can be detected by measuring the peak value of the inrush current through the element 10 and also the remaining life (luminous life) of the element 10 can be estimated from the equivalent capacitance.

A concrete circuit of the detector 15 is next explained with reference to FIG. 1. In order to measure the peak value of an inrush current through the element 10, the detector 15 is formed of, for example, a peak detection circuit 150 and a comparison circuit 155. The circuit 150 is made up of a resistor 151, a voltage follower 152 and a capacitor 153, and supplies the circuit 155 with voltage (detected voltage) corresponding to the peak value of the inrush current through the element 10. The circuit 155 is made up of an OP amp 156 and resistors 157 and 158, and compares the detected voltage with reference voltage obtained through the resistors 157 and 158. If the detected voltage is higher than the reference voltage, the circuit 155 supplies the controller 16 with a HIGH signal representing that the element 10 is normal. The circuit 155 otherwise supplies the controller 16 with a LOW signal representing that the element 10 is not normal. The reference voltage is set to the voltage corresponding to the equivalent capacitance that is determined based on luminous life or degradation condition of organic EL elements. For example, the reference voltage is set to the voltage corresponding to a value smaller than the specified minimum value with respect to inrush currents of normal organic EL elements. In a modified example, the detector 15 may possess an integration circuit instead of voltage follower 152 and detect a current integrated value S from a rise time point to a stable time point of the square-wave voltage as shown in FIG. 3. In another modified example, the detector 15 may detect the equivalent capacitance of the element 10 by measuring rise time of the inrush current.

The controller 16 is made up of, for example, an oscillator, drive circuits for the source 12 and the circuit 13, a control circuit (e.g., various ICs and/or a Micon, etc.) and so on, and performs the first control, second control and so on. For example, in the first control, the controller 16 detects output voltage of the source 12 (the voltage across the capacitor 126) through an output voltage detector (not shown). And based on the detected voltage, the controller 16 generates a PWM control signal so that the output voltage of the source 12 becomes approximately equal to the drive voltage of the element 10, and then supplies the signal to the control terminal (gate) of the element 123. The controller 16 also supplies the elements 131-134 with switching control signals having frequencies each of which has, for example, a specified switching frequency so that the circuit 13 periodically inverts voltage polarity of the direct-current power from the source 12 to generate square-wave voltage. Specifically, forward direction control and reverse direction control are performed alternately and periodically. In the forward direction control, the controller 16 supplies the elements 131 and 134 with turn-on signals and also supplies the elements 132 and 133 with turn-off signals. In this case, the element 10 emits light. In the reverse direction control, the controller 16 supplies the elements 131 and 134 with turn-off signals and also supplies the elements 132 and 133 with turn-on signals. In this case, the element 10 stops emitting light.

In addition, the controller 16 judges whether to maintain the first control or change to the second control based on a signal from the detector 15. That is, at the HIGH signal, the controller 16 continuously operates in accordance with the first control. At the LOW signal, the controller 16 operates in accordance with the predetermined second control for the element 10 which is not normal. In the embodiment, the controller supplies the element 123 with a PWM control signal for lowering the output voltage of the source 12. However, not limited to this, the controller 16 may supply the elements 131-134 with a signal for lowering a rate of the forward direction control time to the reverse direction control time.

The operation of the embodiment is explained. When the driver 11 is activated, the controller 16 supplies a PWM control signal to the element 123 of the source 12 and also supplies the elements 131-134 with switching control signals. Accordingly, the element 10 operates at specified light output. Then, receiving a HIGH signal from the detector 15, the controller 16 continuously operates in accordance with the first control, while receiving a LOW signal from the detector 15, the controller 16 operates in accordance with the second control. In the first control, the element 10 operates at the specified light output. In the second control, the element 10 operates at light output lower than the specified light output.

In the embodiment, if the element 10 is not normal, the driver 11 can operate in accordance with the second control corresponding to the element 10 which is not normal. In the embodiment, the life of the element 10 can be further extended.

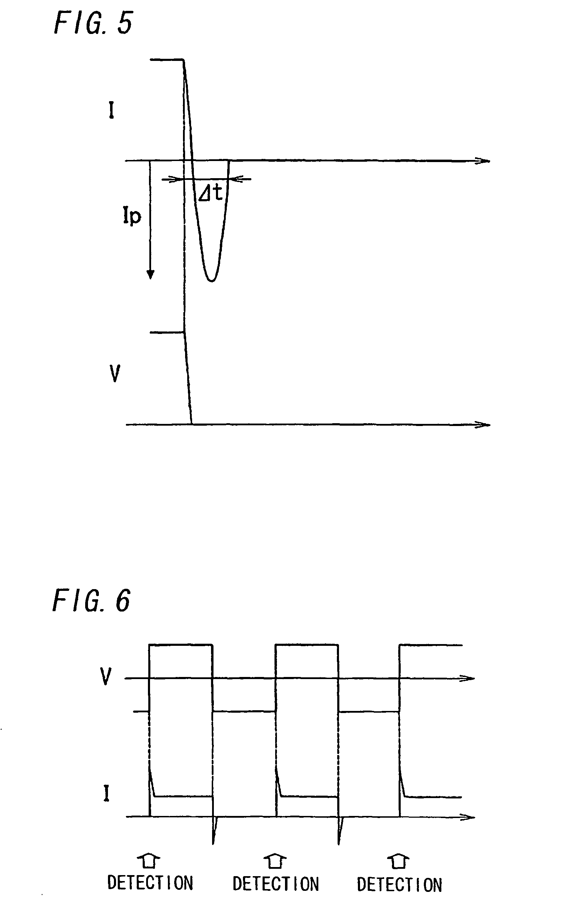

In a modified embodiment, as shown in FIG. 5, the detector 15 measures discharge current waveform in response to a fall in the square-wave voltage applied across the element 10 to detect equivalent capacitance of the element 10.

In another modified embodiment, as shown in FIG. 5, the detector 15 detects equivalent capacitance of the element 10 per period of the square-wave voltage. However, not limited to this, the detector 15 may detect equivalent capacitance of the element 10 per, for example, polarity inversion of the square-wave voltage or constant period of time. In these embodiments, the equivalent capacitance can be always monitored. For example, even if the element 10 is suddenly degraded through noise or lightning surge, the degradation can be promptly detected.

In a modified embodiment, after a predetermined time elapses from a start of the element 10, the detector 15 detects equivalent capacitance of the element 10, for example, only for a constant period of time. In this embodiment, it is possible to detect the equivalent capacitance of the element 10 when the temperature of the driven element 10 is stable.

In a modified embodiment, the detector 15 detects equivalent capacitance of the element 10 only for a predetermined time from a start of the element 10. In this embodiment, equivalent capacitance of the element 10 can be detected without the influence of temperature variation of the element 10.

In a modified embodiment, at the second control, the controller 16 controls the direct-current power source 12 of the square-wave voltage source so as to raise output voltage of the source 12. In this embodiment, light output of the element 10 can be restrained from falling.

In a modified embodiment, at the second control, the controller 16 controls the direct-current power source 12 of the square-wave voltage source so as to change output voltage of the source 12 in response to the equivalent capacitance detected with the detector 15. However, not limited to this, the controller 16 may control the circuit 13 so as to lower a rate of the forward direction control time to the reverse direction control time with respect to the element 19. In these embodiments, the element 10 can be adaptively driven in response to degradation condition of the element 10. For example, luminous life of the element 10 can be extended, and luminous efficiency of the element 10 can be restrained from falling. It is also possible to notify a user of degree of remaining life (luminous life) of the element 10 through change of light output of the element 10.

In a modified embodiment, at the second control, the controller 16 controls the square-wave voltage source so as to stop the output of the source, namely the output of the direct-current power source 12 and the output of the polarity inversion circuit 13. In this embodiment, the element 10 can be prevented from being driven when the element 10 is not normal.

In a modified embodiment, at the first control, the controller 16 supplies the element 10 with square-wave voltage of which each polarity inversion is made gentle so that an inrush current smaller than a prescribed current flows through the element 10. The controller also supplies the element 10 with square-wave voltage of which each polarity inversion is made steep so that an inrush current larger than the prescribed current flows through the element 10 only for detection time through the detector 15. In this embodiment, degradation of the element 10 can be delayed.

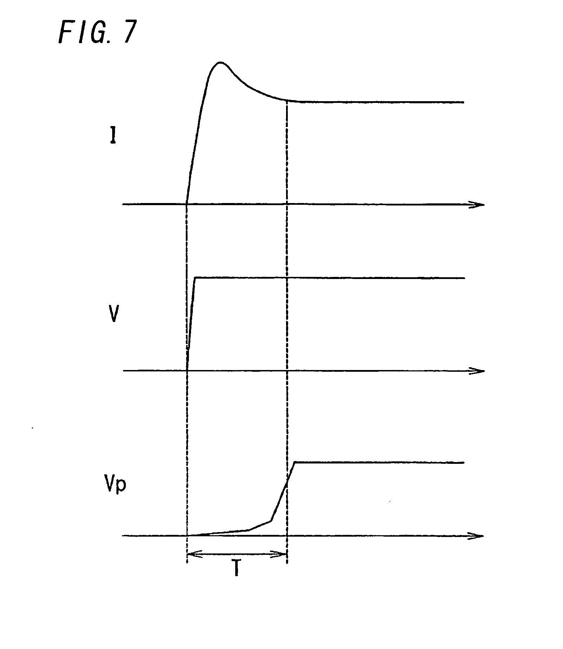

In a modified embodiment, as shown in FIG. 7, the driver 11 further possesses, for example, a photo sensor that converts light of the element 10 into voltage Vp. The controller 16 detects equivalent capacitance of the element 10 based on a detection duration T between a point in time at which square-wave voltage V is supplied to the element 10 and a point in time at which the light output (voltage Vp) detected with the photo sensor reaches a prescribed level. In general, when square-wave voltage is applied across an organic EL element, the current including an inrush current (cf. I of FIG. 7) flows through the element. But the element requires that the capacitor corresponding to equivalent capacitance of the element (cf. C of FIG. 2) needs to be charged until the element emits light at a certain level. That is, the above detection duration has the correlation with the equivalent capacitance of the element 10. In this embodiment, the driver 11 utilizes the correlation to detect equivalent capacitance of the element 10 from the detection duration T.

Although the present invention has been described with reference to certain preferred embodiments, numerous modifications and variations can be made by those skilled in the art within the definition of attached claims. For example, the lighting apparatus of the present invention may possess two or more organic EL elements which are connected in series or parallel with each other.

## Claims

1. An OLED driver, comprising:
a square-wave voltage source (12, 13 and 14) that generates a square-wave voltage and applies the voltage across at least one organic electroluminescence element (10) to drive the element (10) ; and
a controller (16) that controls the source in accordance with a control signal;
**characterized in that**
the driver further comprises a detector (15) that provides a detected voltage based on the detection of the equivalent capacitance inherent in the element (10), said equivalent capacitance being obtained by measuring either:
(i) the peak value of the inrush current (Ip) through the element (10) in response to a rise in the square-wave voltage applied across the element (10); or
(ii) a current integrated value (S) from a rise time point to a stable time point of the square-wave voltage; or
(iii) the rise time (Δt) of the inrush current (Ip) through the element (10) in response to a rise in the square-wave voltage applied across the element (10);
wherein the controller (16) judges whether or not the element (10) is normal based on the result of a comparison between the detected voltage and a reference voltage,
and then operates in accordance with a first control signal if the element (10) is normal, while operating in accordance with a second control signal if the element (10) is not normal;
wherein the reference voltage is set to the voltage corresponding to the equivalent capacitance that is determined based on luminous life or degradation condition of organic electroluminescence elements; and
wherein the detector (15) detects the equivalent capacitance:
(a) per period of the square-wave voltage; or
(b) after a predetermined time elapses from a start of the element (10); or
(c) only for a predetermined time from a start of the element (10).

2. The OLED driver of claim 1, wherein in case of the second control signal, the controller controls the source so as to lower output voltage of the source.

3. The OLED driver of claim 1, wherein in case of the second control signal, the controller controls the source so as to raise output voltage of the source.

4. The OLED driver of claim 1, wherein in case of the second control signal, the controller controls the source so as to change output voltage of the source in response to the equivalent capacitance detected with the detector.

5. The OLED driver of claim 1, wherein in case of the second control signal, the controller controls the source so as to stop the output of the source.

6. Lighting apparatus comprising the OLED driver and said at least one organic electroluminescence element of any one of claims 1 to 5.

## Patentansprüche

1. OLED-Treiber, der Folgendes umfasst:
eine Rechteckspannungsquelle (12, 13 und 14), die eine Rechteckspannung erzeugt und die Spannung über mindestens ein organisches Elektrolumineszenzelement (10) anlegt, um das Element (10) anzusteuern; und
eine Steuerung (16), die die Quelle gemäß einem Steuersignal steuert;
**dadurch gekennzeichnet, dass**
der Treiber ferner einen Detektor (15) umfasst, der eine detektierte Spannung bereitstellt, basierend auf der Detektion der äquivalenten Kapazität, inhärent in dem Element (10), wobei die äquivalente Kapazität erlangt wird durch Messen entweder
(i) der Spitzenspannung des Einschaltstromes (Ip) durch das Element (10) in Reaktion auf einen Anstieg in der Rechteckspannung, die über das Element (10) angelegt ist; oder
(ii) eines integrierten Stromwertes (S) von einem Anstiegszeitpunkt bis zu einem Stabilisierungszeitpunkt der Rechteckspannung oder
(iii)der Anstiegszeit (Δt) des Einschaltstromes (Ip) durch das Element (10) in Reaktion auf einen Anstieg in der Rechteckspannung, die über das Element (10) angelegt ist;
wobei die Steuerung (16) beurteilt, ob das Element (10) basierend auf dem Ergebnis eines Vergleichs zwischen der detektierten Spannung und einer Referenzspannung normal ist oder nicht, und dann gemäß einem ersten Steuersignal arbeitet, falls das Element (10) normal ist, während gemäß einem zweiten Steuersignal gearbeitet wird, wenn das Element (10) nicht normal ist; wobei die Referenzspannung auf die Spannung gesetzt ist, die sich auf die äquivalente Kapazität bezieht, die basierend auf eine Leuchtlebensdauer oder einen Schwächungszustand organischer Elektrolumineszenzelemente bestimmt ist; und
wobei der Detektor (15) die äquivalente Kapazität detektiert:
(a) pro Periode der Rechteckspannung oder
(b) nachdem eine vorgegebene Zeit ab einem Start des Elements (10) verstreicht oder
(c) nur für eine vorgegebene Zeit ab einem Start des Elements (10).

2. OLED-Treiber nach Anspruch 1, wobei im Falle des zweiten Steuersignals die Steuerung die Quelle derart steuert, dass die Ausgangsspannung der Quelle verringert wird.

3. OLED-Treiber nach Anspruch 1, wobei im Falle des zweiten Steuersignals die Steuerung die Quelle derart steuert, dass die Ausgangsspannung der Quelle erhöht wird.

4. OLED-Treiber nach Anspruch 1, wobei im Falle des zweiten Steuersignals die Steuerung die Quelle derart steuert, dass die Ausgangsspannung der Quelle in Reaktion auf die äquivalente Kapazität geändert wird, die mit dem Detektor detektiert wurde.

5. OLED-Treiber nach Anspruch 1, wobei im Falle des zweiten Steuersignals die Steuerung die Quelle derart steuert, dass der Ausgang der Quelle gestoppt wird.

6. Beleuchtungsvorrichtung, die den OLED-Treiber und das mindestens eine organische Elektrolumineszenzelement nach einem der Ansprüche 1 bis 5 umfasst.

## Revendications

1. Pilote de diodes électroluminescentes organiques, comportant :
une source de tension rectangulaire (12, 13 et 14) qui génère une tension rectangulaire et applique la tension à travers au moins un élément électroluminescent organique (10) pour piloter l'élément (10), et
un dispositif de commande (16) qui commande la source conformément à un signal,
**caractérisé en ce que**
le pilote comporte en outre un détecteur (15) lequel délivre une tension détectée sur la base de la détection de la capacité équivalente inhérente à l'élément (10), ladite capacité équivalente étant obtenue en mesurant :
(i) la valeur de crête du courant d'appel (Ip) via l'élément (10) en réponse à une augmentation de la tension rectangulaire appliquée à travers l'élément (10), ou
(ii) une valeur intégrée de courant (S) d'un instant de montée jusqu'à un instant stable de la tension rectangulaire, ou
(iii) le temps de montée (Δt) du courant d'appel (Ip) via l'élément (10) en réponse à une montée de la tension rectangulaire appliquée à travers l'élément (10),
dans lequel le dispositif de commande (16) détermine si oui ou non l'élément (10) est normal sur la base du résultat d'une comparaison entre la tension détectée et une tension de référence, et fonctionne ensuite conformément à un premier signal de commande si l'élément (10) est normal, tout en fonctionnant conformément à un second signal de commande si l'élément (10) n'est pas normal, dans lequel la tension de référence est établie à la tension correspondant à la capacité équivalente qui est déterminée sur la base d'une durée lumineuse ou d'une condition de dégradation d'éléments électroluminescents organiques, et
dans lequel le détecteur (15) détecte la capacité équivalente :
(a) par période de la tension rectangulaire, ou
(b) après qu'une durée prédéterminée se soit écoulée depuis un lancement de l'élément (10), ou
(c) uniquement pendant une durée prédéterminée à partir du lancement de l'élément (10).

2. Pilote de diodes électroluminescentes organiques selon la revendication 1, dans lequel dans le cas du second signal de commande, le dispositif de commande commande la source de manière à réduire la tension de sortie de la source.

3. Pilote de diodes électroluminescentes organiques selon la revendication 1, dans lequel le dispositif de commande commande la source de manière à augmenter la tension de sortie de la source.

4. Pilote de diodes électroluminescentes organiques selon la revendication 1, dans lequel dans le cas du second signal de commande, le dispositif de commande commande la source de manière à changer la tension de sortie de la source en réponse à la capacité équivalente détectée à l'aide du détecteur.

5. Pilote de diodes électroluminescentes organiques selon la revendication 1, dans lequel dans le cas du second signal de commande, le dispositif de commande commande la source de manière à interrompre la sortie de la source.

6. Dispositif d'éclairage comportant le pilote de diodes électroluminescentes organiques et ledit au moins un élément électroluminescent organique selon l'une quelconque des revendications 1 à 5.
